# EUROPÄISCHE PATENTANMELDUNG

(11) **EP 1 507 023 A1**
(43) Veröffentlichungstag der Anmeldung: **16.02.2005**
(21) Anmeldenummer: 04018852.6
(22) Anmeldetag: 09.08.2004
(51) Int. Cl.: C23C 14/48, C23C 8/38

(54) **Legierung zur Herstellung von verschleissresistenten Werkzeugen**

(30) Priorität: 14.08.2003 DE 10337492; 14.08.2003 DE 10337463
(71) Anmelder: Voith Paper Patent GmbH, 89522 Heidenheim (DE)
(72) Erfinder: Brettschneider, Werner, 88214 Ravensburg (DE); Reimann, Stefan, 40670 Meerbusch (DE); Schoof, Ulrich, 40591 Düsseldorf (DE); Schröder, Achim, 51519 Odenthal (DE)
(74) Vertreter: Manitz, Finsterwald & Partner GbR

(57) **Zusammenfassung**

Es wird eine Legierung, sowie ein Verfahren zu deren Herstellung beschrieben, die aus den folgenden Komponentengruppen besteht: a) bis zu etwa 24 % Chrom (Cr) und Mangan (Mn), b) bis zu etwa 5,5 % Kohlenstoff (C), Vanadium (V) und Molybdän (Mo) und c) bis zu etwa 1,23 % Silizium (Si), Niob (Nb), Nickel (Ni), Phosphor (P) und Schwefel (S); Rest Eisen (Fe).

Diese Legierung ist mit besonderem Vorteil insbesondere zur Herstellung von verschleißresistenten Werkzeugen für eine mechanische Behandlung von Zellstofffasern verwendbar.

## Beschreibung

Die Erfindung betrifft eine Legierung, deren Herstellung sowie die Verwendung einer solchen Legierung zur Herstellung von verschleißresistenten Werkzeugen für die mechanische Behandlung von Zellstofffasern.

Werkzeugstähle dienen, wie der Name bereits besagt, der Herstellung diverser Werkzeuge. Sie besitzen einen höheren Kohlenstoffanteil als Baustähle und werden durchwegs gehärtet. Deshalb unterscheidet man sie nach der Art des Abschreckmittels nach Wasser-, Öl- oder Lufthärter. Solche Werkzeugstähle werden in einer Vielzahl von Normen beschrieben. Ein wesentlicher Nachteil dieser Werkzeugstähle besteht jedoch in der lediglich begrenzten Korrosionsfestigkeit.

Beispielsweise bei der Aufbereitung von Zellstoff- oder Papierfasern werden Werkzeuge der oben genannten Art an verschiedenen Stellen eingesetzt. Durch Kontakt mit den wässrig suspendierten Fasern und insbesondere mit den Begleitstoffen, wie mineralischen Füllstoffen und Schmutzpartikeln, tritt an den Werkzeugen ein beträchtlicher Abrieb auf. Bei den jeweiligen Werkzeugen kann es sich beispielsweise um Mahlgarnituren, Dispergergarnituren, Auflöserotoren, Sortiererrotoren oder Siebe handeln.

Demzufolge werden beispielsweise Mahlwerkzeuge von so genannten Refinern, die in der Papierindustrie zur Fasermahlung eingesetzt werden (vgl. z.B. DE 100 32 399 A1) und/oder dergleichen entsprechend vor Verschleiß geschützt. Es liegt in der Natur solcher Werkzeuge, dass sie einem sehr hohen Verschleiß ausgesetzt sind und, da dies seit langem bekannt ist, die Erzeugung verschleißfester Oberflächen solcher Mahlwerkzeuge bereits das Ziel von entsprechenden Entwicklungsarbeiten war. Da z.B. auch das Härten von aus Stahl gefertigten Garnituren nicht immer ausreichend war, wurden in die Oberfläche des Mahlwerkzeugs mit Hilfe eines Plasmas Fremdionen bis zu einer Tiefe von 500 µm eingelagert. Die Fremdionen-Einlagerung erfolgt durch beschleunigte Ionen mit definierter Energie. Die zu implantierenden Fremdionen werden in einem reaktionsfähigen Plasma in die Werkstoffoberfläche eingeschossen. Die Anzahl der implantierten Fremdionen und deren Eindringtiefe ist dabei durch entsprechende Konzentrationen und Wahl der Beschleunigungsspannungen der Fremdionen variabel, d.h. die Anzahl der implantierten Fremdionen und deren Eindringtiefe ist vorgebbar. In der Praxis kann dazu ein Plasmaofen verwendet werden, bei dem ein Plasma auf die Oberfläche des Werkstücks einwirkt. Die in die Oberfläche eindringenden Fremdionen erzeugen dort einen Zustand, der die Festigkeit und Härte der Metallstruktur beträchtlich erhöht, was zu einem starken Anstieg der Verschleißresistenz führt. Im selben Arbeitsgang kann, im Oberflächenbereich des Eisenteiles zusätzlich eine Hartstoffschicht gebildet werden, die den Verschleißschutz weiter verbessert.

Die Abmessungen des Werkstückes werden durch das Implantieren praktisch nicht verändert, so dass ein Nacharbeiten der gehärteten Flächen zumeist entfallen kann.

In der DE 28 04 605 A1 wird ein älteres Verfahren beschrieben, das auch zur Ionenimplantation führen kann.

In der EP 1 113 908 ist ein insbesondere zum Schneiden laufender Materialbahnen bestimmtes Messer beschrieben, bei dem die Oberfläche der Schneidkante mittels eines plasmagestützten Ionenimplantationsprozesses behandelt wird. Ein insbesondere in Papier- und Kartonmaschinen eingesetzter Siebkorb, in dessen Oberfläche Fremdionen bis zu einer Eindringtiefe von 500 µm eingelagert werden, ergibt sich aus der DE 200 21 552 U1.

Ein Ziel der Erfindung ist es, eine Legierung zur Verfügung zu stellen, mit der die bisherigen guten Eigenschaften von Werkzeugstählen bezüglich der Bearbeitung und normalen Wärmebehandlung aufrecht erhalten werden und darüber hinaus gleichzeitig sowohl eine wesentlich erhöhte Korrosionsfestigkeit, eine gute Gießbarkeit und eine gute Aufnahmefähigkeit für eine Ionenimplantation erreicht wird. Mit der betreffenden Legierung soll insbesondere auch erreicht werden, dass die Wirkung des Ionenimplantationsprozesses noch intensiver genutzt werden und unter anderem auch auf weitere Produkte wie beispielsweise Refiner, Disperger, Entstipper usw. ausgeweitet werden kann. Des Weiteren soll ein Verfahren zur Herstellung von verschleißresistenten Werkzeugen zur Verfügung gestellt werden und die Verwendung der verschleißfesten Werkzeuge für die Behandlung von Zellstofffasern.

Diese Aufgabe wird nach der Erfindung gelöst durch eine Legierung, bestehend aus den folgenden Komponentengruppen:
a) bis zu etwa 24 % Chrom (Cr) und Mangan (Mn), b) bis zu etwa 5,5 % Kohlenstoff (C), Vanadium (V) und Molybdän (Mo) und c) bis zu etwa 1,23 % Silizium (Si), Niob (Nb), Nickel (Ni), Phosphor (P) und Schwefel (S); Rest Eisen (Fe).

Die Menge der Komponentengruppe a) Chrom (Cr) und Mangan (Mn) beträgt vorzugsweise etwa 11 %.

Die Menge der Komponentengruppe b) Kohlenstoff (C), Vanadium (V) und Molybdän (Mo) beträgt vorteilhafterweise zumindest etwa 2 %.

Gemäß einer bevorzugten Zusammensetzung der erfindungsgemäßen Legierung besteht diese aus den folgenden Komponenten:
etwa 1 bis 2 % Kohlenstoff (C), < 0,5 % Silizium (Si), etwa 1 bis 4 %, vorzugsweise etwa 1,1 bis 2 % Mangan (Mn), < 0,02 % Phosphor (P), < 0,01 % Schwefel (S), etwa 10 bis 20 % Chrom (Cr), < 0,2 % Nickel (Ni), etwa 0,5 bis 1,5 % Molybdän (Mo), etwa 0,5 bis 2 % Vanadium (V), etwa 0,1 bis 0, 5 % Niob (Nb), Rest Eisen (Fe).

Die Menge der Komponente Kohlenstoff (C) beträgt vorzugsweise etwa 1,5 bis 1,6 %.

Die Menge der Komponente Mangan (Mn) beträgt vorteilhafterweise etwa 1,5 bis 2 %.

Gemäß einer bevorzugten Ausführungsform beträgt die Komponente Chrom (Cr) etwa 14 bis 16 %.

Die Menge der Komponente Nickel (Ni) beträgt vorteilhafterweise etwa 0,1%.

Die Menge der Komponente Molybdän (Mo) beträgt zweckmäßigerweise etwa 0,6 bis 0,9 %.

Bei einer bevorzugten Ausführungsform der erfindungsgemäßen Legierung beträgt die Menge der Komponente Niob (Nb) etwa 0,12 bis 0,15 %.

Ein solchermaßen zusammengesetzter Stahl lässt sich sehr gut gießen, wobei feinste Konturen selbst im Sandformguss noch gut abbildbar sind. Weiter bildet er die Möglichkeit der Bearbeitung und Wärmebehandlung wie bei üblichen Werkzeugstählen. Darüber hinaus reagiert der Stahl auf die Behandlung im Ionenimplantationsprozess äußerst positiv.

In Versuchen wurden nach Vickers gemessene Härten von bis zu 2000 HV nach der Ionenimplantation nachgewiesen. In einer Tiefe von 0, 1 mm wurde immer noch eine Härte von bis zu 1000 HV gemessen.

Es ist eine Beeinflussungstiefe von zumindest bis zu 1 mm (= 1000 µm) möglich.

Die erfindungsgemäße Legierung ist mit besonderem Vorteil zur Herstellung von verschleißresistenten Werkzeugen für die mechanische Behandlung von Zellstofffasern verwendbar, bei der mittels eines plasmagestützten Verfahrens Fremdionen in einen Teil der Oberfläche der Garnitur mit einer Eindringtiefe von mindestens 500 µm eingelagert werden, wobei das mit den Fremdionen zu beaufschlagende Material eines jeweiligen Werkzeuges durch die Legierung eine gezielte Veränderung der molekularen Struktur erfährt, um die Eindringtiefe auf mindestens 600 µm, bevorzugt auf mindestens 700 µm, bevorzugter auf mindestens 800 µm und am meisten bevorzugt auf mindestens 1000 µm zu vergrößern.

Als Fremdionen können insbesondere Stickstoff-, Kohlenstoff-, Molybdän-, Titan-, Wolfram-, Vanadium- und/oder Borionen in das jeweilige Werkzeug eingelagert werden.

Der Verschleißschutz muss nicht gleichmäßig an allen bei Gebrauch des jeweiligen Werkzeuges von Zellstofffasern berührten Flächen vorgesehen werden.

Es kann beispielsweise auch eine zum Mahlen von wässrig suspendierten Zellstofffasern bestimmte, mit Mahlleisten versehene Refinergarnitur hergestellt werden. Dabei ist es denkbar, dass die Oberseite der Mahlleisten weniger intensiv vor Verschleiß geschützt wird als die die Schnittkanten aufweisenden Vorderseiten. Insbesondere mit Messern versehene Mahlgarnituren können völlig unterschiedlich wirken, je nachdem, ob die Schnittkante rechtwinkelig oder abgerundet ist.

Es kann beispielsweise auch eine zum Dispergieren von wässrig suspendierten Zellstofffasern bestimmte Dispergergarnitur hergestellt werden.

Ebenso ist beispielsweise die Herstellung einer zum Entstippen von wässrig suspendierten Zellstofffasern bestimmten Entstippergarnitur denkbar.

Insbesondere ist z.B. bei Mahl-, Disperger- oder Entstippergarnituren deren Wirkung auf den Faserstoff entscheidend durch die Kantenform beeinflusst.

Mit der bevorzugten Verwendung der erfindungsgemäßen Legierung, hergestellt nach dem erfindungsgemäßen Verfahren, wird also eine geänderte Metallstruktur des jeweiligen Werkzeuges genutzt, die auch bei längerem Gebrauch einen erhöhten Widerstand gegen Abrieb und Verschleiß bietet. Dies ist insbesondere darauf zurückzuführen, dass bezüglich der Ionenimplantation eine deutlich höhere Eindringtiefe erreicht wird, was nicht nur zu einer längeren Standzeit des Werkzeugs führt, sondern auch dazu, dass die Form de Werkzeuges über einen längeren Zeitraum weitestgehend unverändert bleibt. Bekanntlich ist gerade bei der mechanischen Behandlung von Zellstofffasern die Form der Werkzeuge von großer Bedeutung, da sie deren Funktion entscheidend beeinflusst. So ist z.B. Mahl-, Disperger- oder Entstippergarnituren deren Wirkung auf den Faserstoff entscheidend durch die Kantenform beeinflusst. Wie bereits erwähnt, können z.B. mit Messern versehene Mahlgarnituren völlig unterschiedlich wirken, je nachdem, ob die Schnittkante rechtwinkelig oder abgerundet ist.

Bei der Ionenimplantation werden in der Regel durch Beschuss von Oberflächen mit energiereichen Ionen Einlagerungen dieser Ionen in die Randbereiche der Materialien und häufig auch Strukturveränderungen erreicht. Dies lässt sich unter anderem gemäß dem folgenden Beispiel vorteilhaft durchführen:

Zwischen dem zu bearbeitenden Werkstück und einer Elektrode (Target) wird eine Beschleunigungsspannung, insbesondere eine frequente Gleichspannung angelegt. Das Werkstück wird vorwiegend als Kathode und das Target vorwiegend als Anode geschaltet. Die Kammer (Retorte), in der das Verfahren ausgeführt werden soll, wird evakuiert und mit einem reaktionsfähigen Behandlungsgas gefüllt. Bei einem definierten konstanten Unterdruck wird die Gasentladung durch Anlegen einer die Beschleunigungsspannung bildende Basisspannung mit überlagerten hochfrequenten Impulsen eingeleitet. Bei der Gasentladung wird das Behandlungsgas ionisiert, und die entstandenen Ionen werden in Richtung auf die Werkzeugoberfläche einerseits und das Target andererseits beschleunigt. Treffen die Ionen auf die Oberfläche des Werkzeuges auf, wird die Oberfläche durch Abstäuben von Atomen gereinigt. Die zugeführten Reaktionsgase zerfallen und kondensieren an der Oberfläche, was zu Metallverbindungen führt. Diese Metallverbindungen werden transkristallin in das Gefüge des Werkzeuges implantiert. Das Verfahren wird bei Temperaturen ausgeführt, die weder die Form noch die Metallstruktur des Werkzeuges nachteilig verändern können, z.B. bei 70°C bis maximal 350°C. Wie bereits angedeutet, besteht grundsätzlich auch die Möglichkeit, den Verschleißwiderstand der Werkzeuge an verschiedenen Stellen unterschiedlich auszugestalten. Auch kann der Vorteil des Ionenimplantationsprozesses, nämlich die Steuerung des Ionenflusses mit Hilfe von elektrischen Feldern, zu lokal unterschiedlichen Intensitäten des Verschleißschutzes genutzt werden.

Mit Hilfe des erfindungsgemäßen Verfahrens besteht auch die Möglichkeit, den Verschleißwiderstand der Werkzeuge an verschiedenen Stellen unterschiedlich auszugestalten. Es ist nämlich vorstellbar, dass an bestimmten Stellen des Werkzeuges dieser Verschleißschutz gerade nicht gewünscht wird. So kann es z.B. in dem bereits genannten Fall von Messergarnituren zur Zellstoffmahlung von Vorteil sein, den Verschleißwiderstand der Vorderseite einer Messerleiste größer einzustellen als den der Oberseite. Das lässt sich z.B. dadurch realisieren, dass die Hartstoffschicht nicht oder nur in beträchtlich dünnerer Form auf der Oberseite der Messer erzeugt wird. Auch kann der Vorteil der Implantationsverfahren, nämlich die Steuerung des Ionenflusses mit Hilfe von elektrischen Feldern, zur lokal unterschiedlichen Intensität des Verschleißschutzes genutzt werden. Sollte die Oberseite der Messerleiste ohne zusätzlichen Verschleißschutz bleiben, wäre diese durch eine elektrische Isolierschicht abzudecken. Eine wichtige und typische Ausführungsform des Verfahrens besteht darin, das Werkzeug aus einer Chrom-Nickel-Stahl-Legierung herzustellen mit einer Zugabe von mindestens 1% Mangan, vorzugsweise ca. 1,5% . Eine solche Legierung begünstigt das Eindringen der Fremdionen, d.h. es wird ein Eindringtiefe von 1 bis zu 3 mm erreicht. Außerdem lässt sie sich gut gießen und entwickelt Festigkeiten wie sie für solche Werkzeuge günstig sind.

Die Erfindung wird im Folgenden anhand von Zeichnungen und/oder Ausführungsbeispielen unter Bezugnahme auf die Zeichnung näher erläutert; in dieser zeigen:
- Figur 1: Teil einer erfindungsgemäß hergestellten Mahlgarnitur, geschnitten in perspektivischer Ansicht;
- Figur 2: Detail einer speziellen Mahlgarnitur;
- Figur 3: Detail der Mahlgarnitur aus Fig. 2 in gebrauchtem Zustand;
- Figur 4: zwei erfindungsgemäß hergestellte im Disperger in Betriebsposition eingesetzte Dispergergarnituren;
- Figur 5: ähnliche Dispergergarnituren in Aufsicht;
- Figur 6: den Gusszustand eines Abschnitts eines betreffenden Werkzeuges;
- Figur 7: den weichgeglühten Zustand des betreffenden Abschnitts des Werkzeuges;
- Figur 8: den vergüteten Zustand des betreffenden Abschnitts des Werkzeuges;
- Figur 9: eine Probe des Werkzeuges nach der Ionenimplantation und
- Figuren 10 bis 12: unterschiedliche Härtverlaufsdiagramme, wobei die Streuung unterschiedlichen Verfahrensparametern der Ionenimplantation entspricht.

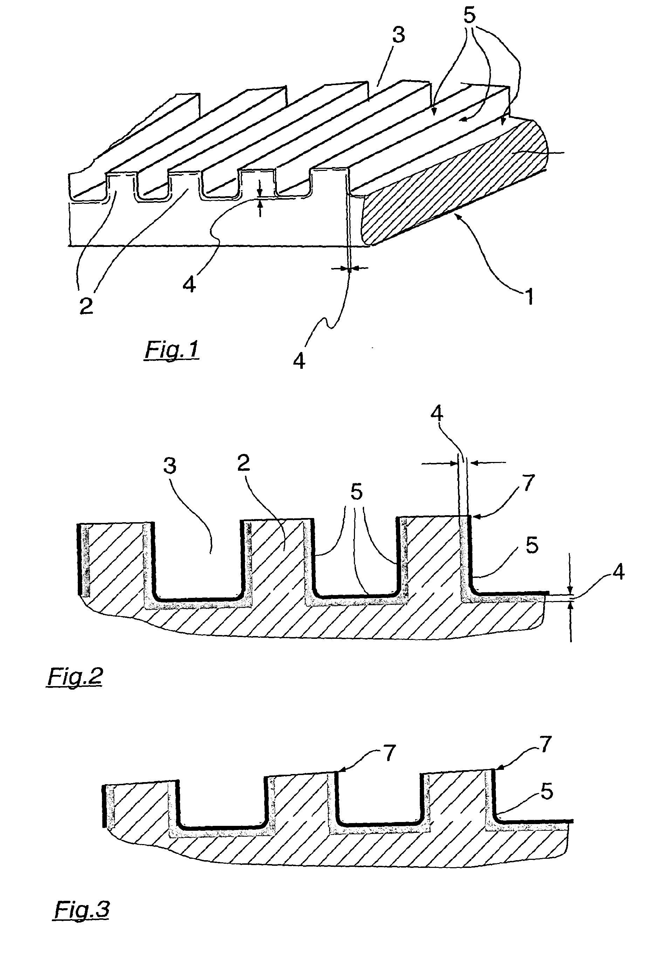

Die in Fig. 1 gezeigte Mahlgarnitur 1 dient der Mahlung von wässrig suspendierten Zellstofffasern. Sie weist eine größere Anzahl von Mahlleisten 2 auf, die auch als Messer bezeichnet werden. Zwischen diesen befindet sich jeweils eine Nut 3. Eine solche Mahlgarnitur arbeitet mit einer nicht gezeigten Gegengarnitur in an sich bekannter Weise zusammen. Sie besteht überwiegend aus legiertem Stahl und kann mit Vorteil gegossen sein. Um die Verschleißfestigkeit zu erhöhen, sind an den vom Faserstoff benetzten Flächen von der Oberfläche her Fremdionen implantiert. Dabei ist eine Eindringtiefe 4 erreicht worden, die größer ist als 0,5 mm, vorzugsweise ca. 1 mm. Zusätzlich ist eine Hartstoffschicht 5 in die Oberfläche des Werkzeugs eingelagert. Diese ist im Allgemeinen relativ dünn, z.B. 0,1 mm. Sie ist aber nicht unbedingt erforderlich.

Um die Mahlkantenform der Garnitur auch für eine längere Betriebsdauer zu erhalten, kann es sinnvoll sein, die Oberseite 6 der Mahlleisten 2 weniger vor Verschleiß zu schützen als die Vorderseiten, insbesondere die Schnittkanten 7. Das ist schematisch in Fig. 2 dargestellt, gemäß der an der Oberseite 6 keine Ionenimplantation erfolgte und keine Hartstoffschicht 5 erzeugt wurde. Bei Betrieb einer solchen Garnitur wird die Oberseite 6 stärker abgetragen als die Flanken der Mahlleiste 2, so dass die Schnittkante 7 ständig nachgeschärft wird (s. Fig. 3).

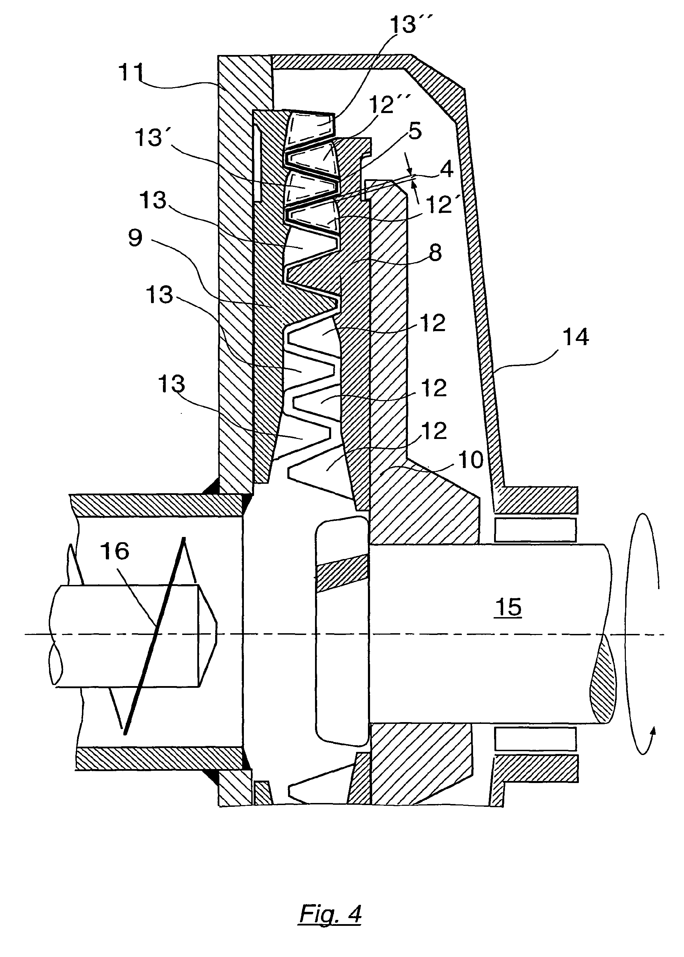

Fig. 4 zeigt zwei unter Anwendung des Verfahrens hergestellte Dispergergarnituren, die in einem Gehäuse 14 eingebaut sind und in Betriebsposition stehen. Bekanntlich wird das Dispergieren von Zellstofffasern bei relativ hoher Konsistenz (15 bis 30 %) durchgeführt, um eine intensive Faser-Faser-Reibung zu erzeugen. Dispergergarnituren sind z.B. aus der DE 100 17 898 A1 bekannt. Wegen der hohen Viskosität des Faserstoffs beim Dispergieren erfolgt die Zuführung durch eine Förderschnecke 16. Dispergergarnituren enthalten eine Vielzahl von in konzentrischen Ringen angeordneten Zähnen, die axial ineinander greifen, ohne sich zu berühren und relativ zu einander bewegt werden. Dabei wird zwischen ihnen ein Abstand von z.B. ca. 1 bis 5 mm eingehalten. Die Relativbewegung erfolgt in der Regel dadurch, dass eine Rotorgarnitur 8 auf einem von einer Welle 15 angetriebenen Rotor 10 bewegt wird, während die Gegengarnitur, eine Statorgarnitur 9 in einem Stator 11 drehfest fixiert ist. Bei der in Fig. 4 verwendeten Ansicht ist von jedem der Garniturringe jeweils ein Zahn, und zwar rotorseitig Zähne 12 bzw. 12' bzw. 12", statorseitig Zähne 13 bzw. 13' bzw. 13", sichtbar. Angedeutet ist der Verschleißschutz durch gestrichelte Linien für die Eindringtiefe der Ionenimplantation und fette Linien für die Hartstoffschicht. Auch beim Schutz solcher Dispergergarnituren kann das Verfahren mit Vorteil variiert werden, indem der Verschleißschutz nicht auf alle stoffberührten Teile gleichmäßig aufgebracht wird. So sind bei dem hier gezeigten Beispiel lediglich die besonders verschleißgefährdeten Zähne 12' 12" bzw. 13', 13", die zu den beiden radial äußeren Zahnreihen gehören, durch das erfindungsgemäße Verfahren gegen Verschleiß besonders geschützt. Selbstverständlich kann aber in anderen Fällen der Verschleißschutz auch auf entsprechend mehr oder weniger Zahnreihen angewendet werden. Hier kann durch einfache Versuche festgestellt werden, bei welcher Anwendung eine bestimmte Ausgestaltung des Verfahrens zweckmäßig und wirtschaftlich ist, was die Auswahl der zu schützenden Oberflächen betrifft.

Ähnlich wie schon bei den Mahlgarnituren beschrieben, können in speziellen Fällen auch hier z.B. die Oberseiten der Zähne mit einem geringeren Verschleißschutz versehen sein. Dadurch reduziert sich bei längerer Betriebsdauer die Zahnhöhe durch Abrieb. Die für die Funktion wichtigen Abstände der aneinander vorbei bewegten Zahnflanken können dann leichter durch Axialverstellung der Garnituren gegeneinander ausgeglichen werden.

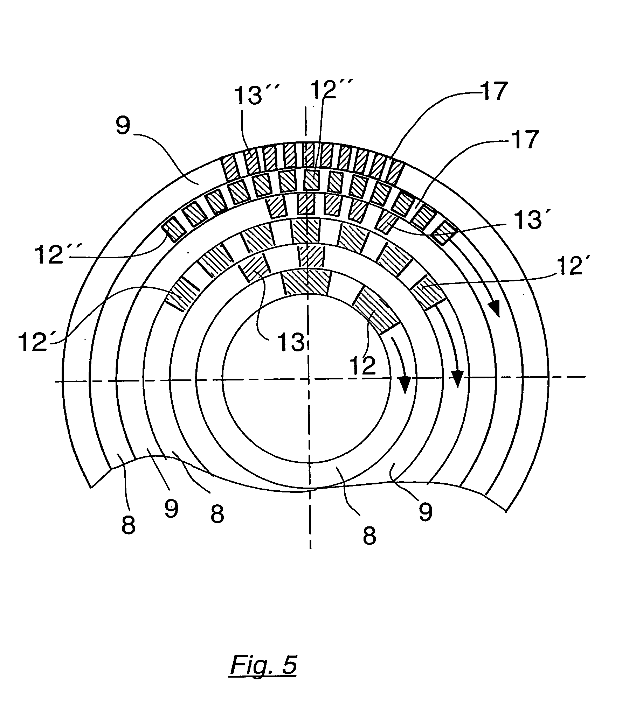

In Fig. 5 sind zwei Dispergergarnituren in Aufsicht dargestellt mit Blickrichtung auf die zum Stator gehörende Gegengarnitur 9. Beide Garnituren weisen je drei mit Zähnen versehene Ringe auf. Von der Rotorgarnitur 8 sind einige Zähne 12, 12', 12" im Schnitt dargestellt. Aus dispergier-technologischen Gründen werden Zähne und die dazwischen liegenden Schlitze 17 radial außen zumeist kleiner ausgestaltet als weiter innen. Wegen der Vielzahl von Flächen, die vor Verschleiß zu schützen sind, ist das erfindungsgemäße Verfahren auch hier besonders vorteilhaft anzuwenden.

Ähnliches gilt auch für Entstippergarnituren, die zwar unter ganz anderen Bedingungen eingesetzt werden, aber ähnlich wie Dispergergarnituren aufgebaut sind und ohne gegenseitige Berührung aneinander vorbei bewegt werden. Sie bearbeiten eine pumpfähige Faserstoffsuspension (Konsistenz z.B. 3 bis 6 %) derart, dass sich Faseragglomerate, sogenannte Stippen, auflösen. Auch Entstippergarnituren sind beträchtlichem Verschleiß ausgesetzt und können durch das Verfahren wirksam verbessert werden.

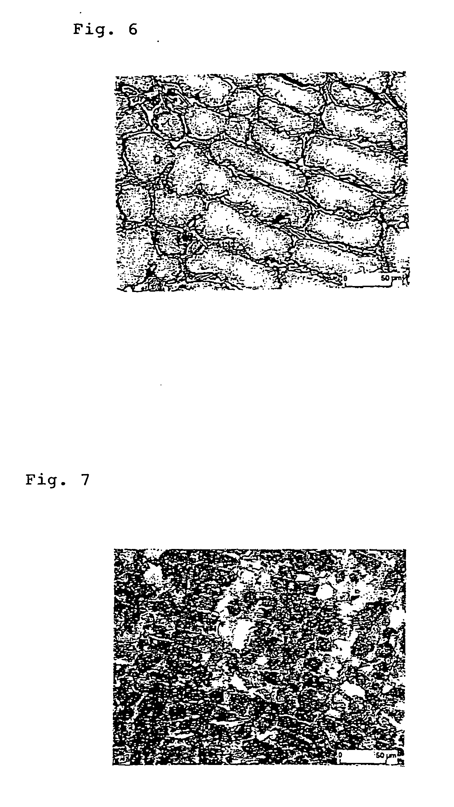

Anhand der Figuren 6 bis 12 werden verschiedene Ausführungsbeispiele einer erfindungsgemäßen, für den Einsatz in Ionenimplantationsverfahren optimierten Legierung beschrieben, die aus den folgenden Komponenten besteht: a) bis zu etwa 24 % Chrom (Cr) und Mangan (Mn), b) bis zu etwa 5,5 % Kohlenstoff (C), Vanadium (V) und Molybdän (Mo) und c) bis zu etwa 1,23 % Silizium (Si), Niob (Nb), Nickel (Ni), Phosphor (P) und Schwefel (S);
Rest Eisen (Fe).

Dabei kann die Menge der Komponentengruppe a) Chrom (Cr) und Mangan (Mn) beispielsweise zumindest etwa 11 % und/oder die Menge der Komponentengruppe b) Kohlenstoff (C), Vanadium (V) und Molybdän (Mo) zumindest etwa 2 % betragen.

Bei einem speziellen Ausführungsbeispiel besteht die Legierung aus den folgenden Komponenten:
etwa 1 bis 2 % Kohlenstoff (C), < 0,5 % Silizium (Si), etwa 1 bis 4 %, vorzugsweise etwa 1,1 bis 2 % Mangan (Mn), < 0,02 % Phosphor (P), < 0,01 % Schwefel (S), etwa 10 bis 20 % Chrom (Cr), < 0,2 % Nickel (Ni), etwa 0,5 bis 1,5 % Molybdän (Mo), etwa 0,5 bis 2 % Vanadium (V), etwa 0,1 bis 0, 5 % Niob (Nb), Rest Eisen (Fe).

Dabei sind bevorzugt auch sämtliche Komponenten, für die jeweils nur eine obere Grenze angegeben ist, in der Legierung enthalten. Die jeweilige Menge auch dieser Komponenten liegt also jeweils vorzugsweise über 0 %.

Ein solchermaßen zusammengesetzter Stahl lässt sich sehr gut gießen, wobei feinste Konturen selbst im Sandformguss noch gut abbildbar sind. Weiter bildet er die Möglichkeit der Bearbeitung und Wärmebehandlung wie bei üblichen Werkzeugstählen. Darüber hinaus reagiert der Stahl auf die Behandlung im Ionenimplantationsprozess äußerst positiv. In Versuchen wurden nach Vickers gemessene Oberflächenhärten von bis zu 2000 HV nach der Ionenimplantation nachgewiesen. In einer Tiefe von 0,1 mm wurde immer noch eine Härte von bis zu 1000 HV gemessen. Eine Beeinflussungstiefe von bis zu 1 mm ist möglich.

Der Gefügezustand stellt sich wie folgt dar:

In dem in der Figur 6 wiedergegebenen Gusszustand liegt eine weiße Grundmasse mit netzartigem Ledeburit und punktförmigen Sekundärkarbiden vor.

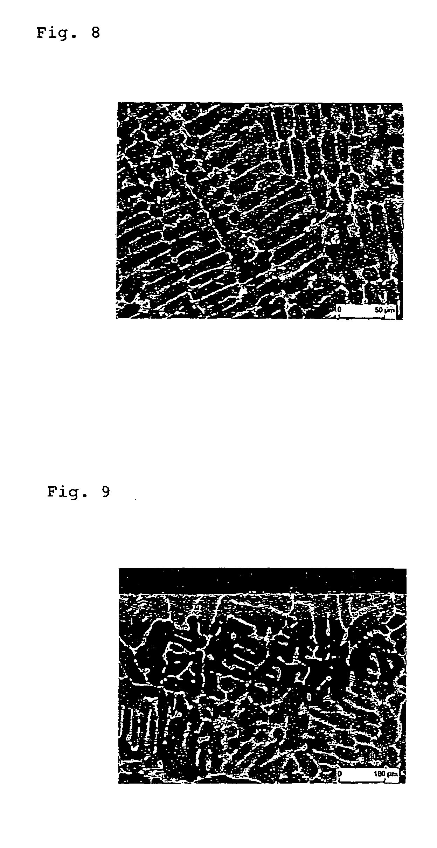

Figur 7 gibt den weichgeglühten Zustand wieder, in dem eine ferritische Grundmasse mit kugelig eingeformten Karbiden und einem Ledeburitnetzwerk vorliegt.

In dem vergüteten Zustand gemäß Figur 8 liegt ein feinnadeliger, teils im Zerfall befindlicher Martensit in einem Ledeburitnetzwerk vor.

Figur 9 zeigt eine Probe nach der Ionenimplantation. Da nur der Randbereich beeinflusst wird, wurde der Schnitt an eine Kante gelegt.

Deutlich sichtbar ist, dass keine Anlagerung von Karbiden oder Nitriden an den Korngrenzen stattfindet. Das Ledeburitnetzwerk ist noch voll vorhanden. Lediglich eine schwache Verfärbung der Probe im Randbereich ist erkennbar, die auf eine unterschiedliche Reaktion auf die zum Ätzen verwendete Salpetersäure zurückzuführen ist.

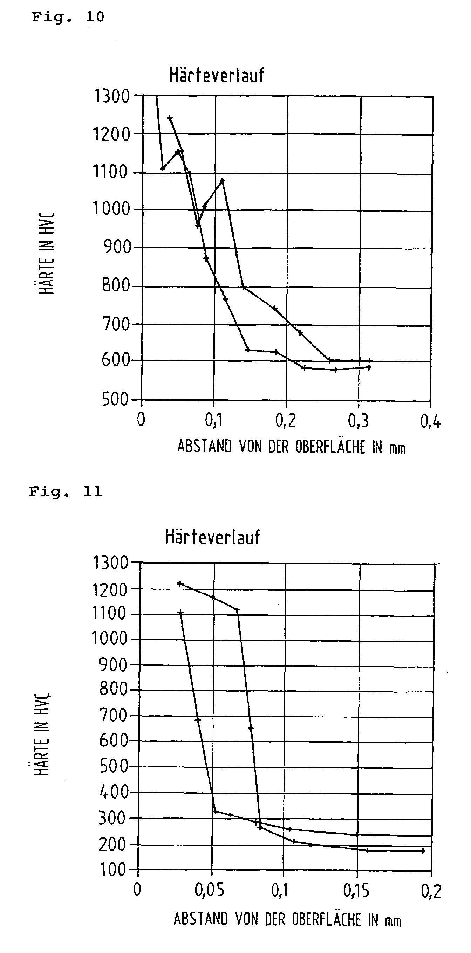

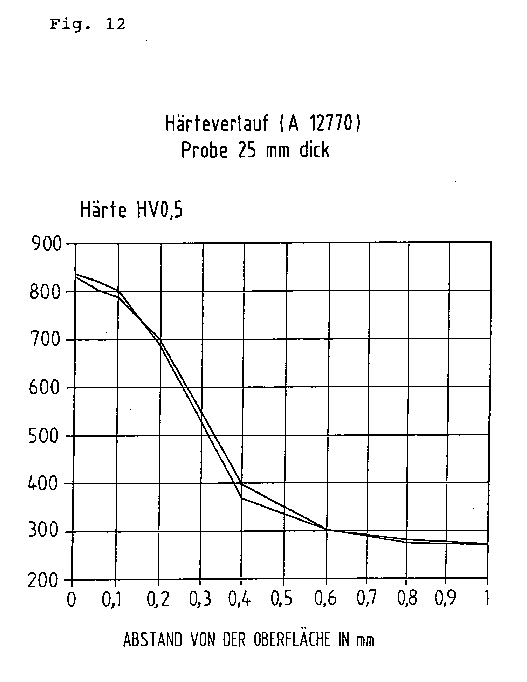

In den Figuren 10 bis 12 sind unterschiedliche Härteverlaufsdiagramme dargestellt. Dabei ist auf der Abszisse jeweils der Abstand von der Oberfläche in mm und auf der Ordinate die Härte dargestellt. Die Figur 12 betrifft den Härteverlauf (A 12770) für eine Probe von einer Dicke von 25 mm. Die unterschiedlichen Streuungen in den verschiedenen Härteverlaufsdiagrammen entsprechen unterschiedlichen Verfahrensparametern der Ionenimplantation.

Die erfindungsgemäße Legierung ist mit besonderem Vorteil zur Herstellung von verschleißresistenten Werkzeugen für die mechanische Behandlung von Zellstofffasern verwendbar, bei der mittels eines plasmagestützten Verfahrens Fremdionen in einen Teil der Oberfläche der Garnitur mit einer Eindringtiefe von mindestens 500 µm eingelagert werden, wobei das mit den Fremdionen zu beaufschlagende Material eines jeweiligen Werkzeuges durch die Legierung eine gezielte Veränderung der molekularen Struktur erfährt, um die Eindringtiefe auf mindestens 600 µm, bevorzugt auf mindestens 700 µm, bevorzugter auf mindestens 800 µm und am meisten bevorzugt auf mindestens 1000 µm zu vergrößern.

## Patentansprüche

1. Legierung, bestehend aus den folgenden Komponentengruppen:
a) bis zu etwa 24 % Chrom (Cr) und Mangan (Mn), b) bis zu etwa 5,5 % Kohlenstoff (C), Vanadium (V) und Molybdän (Mo) und c) bis zu etwa 1,23 % Silizium (Si), Niob (Nb), Nickel (Ni), Phosphor (P) und Schwefel (S);
Rest Eisen (Fe).

2. Legierung nach Anspruch 1,
**dadurch gekennzeichnet,**
**dass** die Menge der Komponentengruppe a) Chrom (Cr) und Mangan (Mn) zumindest etwa 11 % beträgt.

3. Legierung nach Anspruch 1 oder 2,
**dadurch gekennzeichnet,**
**dass** die Menge der Komponentengruppe b) Kohlenstoff (C), Vanadium (V) und Molybdän (Mo) zumindest etwa 2 % beträgt.

4. Legierung nach einem der Ansprüche 1 bis 3,
bestehend aus den folgenden Komponenten:
etwa 1 bis 2 % Kohlenstoff (C), < 0,5 % Silizium (Si), etwa 1 bis 4 %, vorzugsweise etwa 1,1 % bis 2 % Mangan (Mn), < 0,02 % Phosphor (P), < 0,01 % Schwefel (S), etwa 10 bis 20 % Chrom (Cr), < 0,2 % Nickel (Ni), etwa 0,5 bis 1,5 % Molybdän (Mo), etwa 0,5 bis 2 % Vanadium (V), etwa 0,1 bis 0, 5 % Niob (Nb), Rest Eisen (Fe).

5. Legierung nach einem der Ansprüche 1 bis 4,
**dadurch gekennzeichnet,**
**dass** die Menge der Komponente Kohlenstoff (C) etwa1,5 bis 1,6 % beträgt.

6. Legierung nach einem der Ansprüche 1 bis 5,
**dadurch gekennzeichnet,**
**dass** die Menge der Komponente Mangan (Mn) etwa 1,5 bis 2 % beträgt.

7. Legierung nach einem der Ansprüche 1 bis 6,
**dadurch gekennzeichnet,**
**dass** die Menge der Komponente Chrom (Cr) etwa 14 bis 16 % beträgt.

8. Legierung nach einem der Ansprüche 1 bis 7,
**dadurch gekennzeichnet,**
**dass** die Menge der Komponente Nickel (Ni) etwa 0,1 % beträgt.

9. Legierung nach einem der Ansprüche 1 bis 8,
**dadurch gekennzeichnet,**
**dass** die Menge der Komponente Molybdän (Mo) etwa 0,6 bis 0,9 % beträgt.

10. Legierung nach einem der Ansprüche 1 bis 9,
**dadurch gekennzeichnet,**
**dass** die Menge der Komponente Niob (Nb) etwa 0,12 bis 0,15 % beträgt.

11. Verfahren zur Herstellung von verschleißresistenten Werkzeugen für die mechanische Behandlung von Zellstofffasern, bei dem mittels eines plasmagestützten Verfahrens Fremdionen zumindest in einen Teil der Oberfläche der Garnitur mit einer Eindringtiefe von mindestens 500 µm eingelagert werden,
**dadurch gekennzeichnet,**
**dass** das Material des Werkzeuges vor dem Einlagern der Fremdionen durch Legierungszusätze so verändert wird, dass zumindest im Bereich des Eindringens der Fremdionen eine gezielte Veränderung der molekularen Struktur vorgenommen wird, um die Eindringtiefe auf mindestens 600 µm, bevorzugt auf mindestens 700 µm, bevorzugter auf mindestens 800 µm und am meisten bevorzugt auf mindestens 1000 µm, zu vergrößern.

12. Verfahren nach Anspruch 11,
**dadurch gekennzeichnet,**
**dass** die Veränderung der Gitterstruktur durch Legieren des Materials mit Mangan in einer Konzentration von mindestens 1 %, vorzugsweise mindestens 1,5 %, vorgenommen wird.

13. Verfahren nach Anspruch 11 oder 12,
**dadurch gekennzeichnet,**
**dass** das Material vor dem Einlagern der Fremdionen aus einem Chrom-Nickelstahl mit mindestens 10 %, vorzugsweise 15 %, Chrom besteht.

14. Verfahren nach einem der Ansprüche 11 bis 13,
**dadurch gekennzeichnet,**
**dass** als Fremdionen Stickstoff-, Kohlenstoff-, Molybdän-, Titan-, Wolfram-, Vanadium- und/oder Borionen in das Werkzeug eingelagert werden.

15. Verfahren nach einem der Ansprüche 11 bis 14,
**dadurch gekennzeichnet,**
**dass** eine Hartstoffschicht in die Oberfläche des Werkzeuges eingelagert wird.

16. Verfahren nach Anspruch 15,
**dadurch gekennzeichnet,**
**dass** die Hartstoffschicht Nitrid, Karbid und/oder Oxid, Karbonitrid und/oder Oxikarbonitrid die Elemente der Gruppen IV b, V b, VI b des periodischen Systems oder aus einem Nitrid der Elemente Bor, Aluminium, Silizium, Molybdän, Wolfram oder aus Titankarbonitrid und/oder Titannitrid aufweist.

17. Verfahren nach Anspruch 15 oder 16,
**dadurch gekennzeichnet,**
**dass** das Einlagern von Fremdionen in das Werkzeug und das Einlagern einer Hartstoffschicht in die Oberfläche des Werkzeuges in einem Arbeitsgang erfolgt.

18. Verfahren nach einem der Ansprüche 11 bis 17,
**dadurch gekennzeichnet,**
**dass** das Werkzeug vor dem Implantieren bereits in den endgültigen Abmessungen hergestellt wird.

19. Verfahren nach einem der Ansprüche 11 bis 18,
**dadurch gekennzeichnet,**
**dass** das Werkzeug vor dem Implantieren als Gussteil hergestellt wird.

20. Verfahren nach einem der Ansprüche 11 bis 19,
**dadurch gekennzeichnet,**
**dass** der Verschleißschutz nicht gleichmäßig an allen bei Gebrauch des Werkzeuges von Zellstofffasern berührten Flächen aufgebracht wird.

21. Verfahren nach einem der Ansprüche 11 bis 20,
**dadurch gekennzeichnet,**
**dass** Mahlgarnituren (1) hergestellt werden, die Mahlleisten (2) aufweisen und zum Mahlen von wässrig suspendierten Zellstofffasern geeignet sind.

22. Verfahren nach Anspruch 21,
**dadurch gekennzeichnet,**
**dass** die Oberseite der Mahlleisten (2) weniger intensiv vor Verschleiß geschützt wird als die die Schnittkanten (7) aufweisenden Vorderseiten.

23. Verfahren nach einem der Ansprüche 11 bis 20,
**dadurch gekennzeichnet,**
**dass** Dispergergarnituren (8) hergestellt werden, die zum Dispergieren von wässrig suspendierten Zellstofffasern geeignet sind.

24. Verfahren nach einem der Ansprüche 11 bis 20,
**dadurch gekennzeichnet,**
**dass** Entstippergarnituren hergestellt werden, die zum Entstippen von wässrig suspendierten Zellstofffasern geeignet sind.

25. Verwendung der Legierung nach einem der vorhergehenden Ansprüche zur Herstellung von verschleißresistenten Werkzeugen für die mechanische Behandlung von Zellstofffasern, bei der mittels eines plasmagestützten Verfahrens Fremdionen in einen Teil der Oberfläche der Garnitur mit einer Eindringtiefe von mindestens 500 µm eingelagert werden, wobei das mit den Fremdionen zu beaufschlagende Material eines jeweiligen Werkzeuges durch die Legierung eine gezielte Veränderung der molekularen Struktur erfährt, um die Eindringtiefe auf mindestens 600 µm, bevorzugt auf mindestens 700 µm, bevorzugter auf mindestens 800 µm und am meisten bevorzugt auf mindestens 1000 µm zu vergrößern.

26. Verwendung nach Anspruch 25,
**dadurch gekennzeichnet,**
**dass** als Fremdionen Stickstoff-, Kohlenstoff-, Molybdän-, Titan-, Wolfram-, Vanadium- und/oder Borionen in das jeweilige Werkzeug eingelagert werden.

27. Verwendung nach Anspruch 25 oder 26,
**dadurch gekennzeichnet,**
**dass** der Verschleißschutz nicht gleichmäßig an allen bei Gebrauch des jeweiligen Werkzeuges von Zellstofffasern berührten Flächen aufgebracht wird.

28. Verwendung nach einem der Ansprüche 25 bis 27,
**dadurch gekennzeichnet,**
**dass** eine zum Mahlen von wässrig suspendierten Zellstofffasern bestimmte, mit Mahlleisten versehene Refinergarnitur hergestellt wird.

29. Verwendung nach Anspruch 28,
**dadurch gekennzeichnet,**
**dass** die Oberseite der Mahlleisten weniger intensiv vor Verschleiß geschützt wird als die die Schnittkanten aufweisenden Vorderseiten.

30. Verwendung nach einem der Ansprüche 25 bis 27,
**dadurch gekennzeichnet,**
**dass** eine zum Dispergieren von wässrig suspendierten Zellstofffasern bestimmte Dispergergarnitur hergestellt wird.

31. Verwendung nach einem der Ansprüche 25 bis 27,
**dadurch gekennzeichnet,**
**dass** eine zum Entstippen von wässrig suspendierten Zellstofffasern.
